(19) **Europäisches Patentamt**

**European Patent Office**

**Office européen des brevets**

(11) **EP 0 905 892 B1**

(12) **EUROPÄISCHE PATENTSCHRIFT**

(45) Veröffentlichungstag und Bekanntmachung des Hinweises auf die Patenterteilung:
**02.10.2002 Patentblatt 2002/40**

(51) Int Cl.[7]: **H03K 3/037**

(21) Anmeldenummer: **98114223.5**

(22) Anmeldetag: **29.07.1998**

(54) **RS-Flip-Flop mit Enable-Eingängen**

RS flipflop with enable inputs

Bascule RS avec des entrées de validation

(84) Benannte Vertragsstaaten:
**DE FR GB IE IT**

(30) Priorität: **30.09.1997 DE 19743347**

(43) Veröffentlichungstag der Anmeldung:
**31.03.1999 Patentblatt 1999/13**

(73) Patentinhaber: **Infineon Technologies AG**
**81669 München (DE)**

(72) Erfinder:
• **Johnson, Bret**
**81737 München (DE)**
• **Schneider, Ralf**
**81925 München (DE)**

(74) Vertreter: **Müller - Hoffmann & Partner Patentanwälte,**
**Innere Wiener Strasse 17**
**81667 München (DE)**

(56) Entgegenhaltungen:
**EP-A- 0 315 301      WO-A-99/03202**
**US-A- 4 617 480      US-A- 5 541 881**

**Beschreibung**

Die vorliegende Erfindung bezieht sich auf ein RS-Flip-Flop mit einem mit einem Eingangsanschluß verbundenen Inverter, einem einen Enable-Set-Anschluß aufweisenden NOR-Gatter und einem einen Enable-Reset-Anschluß aufweisenden NAND-Gatter und jeweils einem mit dem Inverter verbundenen ersten und zweiten Transistor.

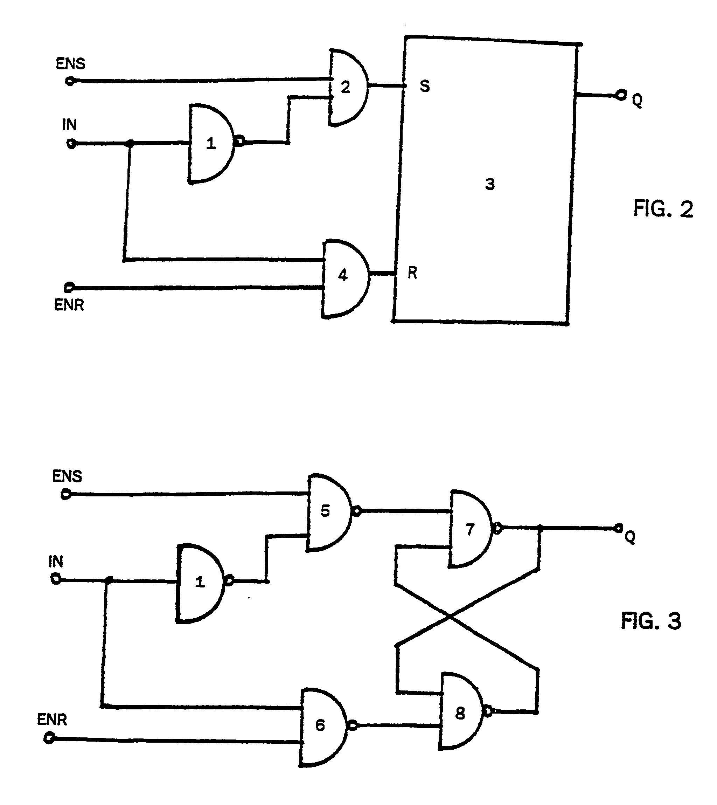

Ein bestehendes RS-Flip-Flop mit Enable-Eingängen ist beispielsweise in der in Figur 2 gezeigten Weise aufgebaut: Ein Eingangsanschluß IN des RS-Flip-Flops ist mit einem Eingang eines Inverters 1 verbunden, dessen Ausgang an einem Eingang eines UND-Gatters 2 liegt. Der andere Eingang des UND-Gatters 2 ist mit einem Eingangs- bzw. Enable-Set-Anschluß ENS verbunden. Der Ausgang des UND-Gatters 2 ist an den Set-Anschluß eines Flip-Flops 3 angeschlossen. Außerdem ist der Eingangsanschluß IN mit einem Eingang eines zweiten UND-Gatters 4 verbunden, an dessen anderen Eingang ein Eingangsanschluß ENR für ein Enable-Reset-Signal angeschlossen ist. Der Ausgang des zweiten UND-Gatters 4 ist mit dem Reset-Eingang des Flip-Flops 3 verbunden.

Bei der gezeigten Schaltung ist es wie in der folgenden Schaltung möglich, daß ein Signal am Anschluß ENS das invertierte Signal zu dem Signal am Anschluß ENR sein kann (ENS = $\overline{\text{ENR}}$).

Figur 3 zeigt einen konkreten Schaltungsaufbau mit dem Flip-Flop 3, wobei hier an die Stelle der UND-Gatter 2, 4 NANDgatter 5, 6 treten und das eigentliche Flip-Flop 3 aus zwei weiteren NAND-Gattern 7, 8 besteht, von denen jeweils ein Ausgangsanschiuß auf einen Eingangsanschluß des anderen NAND-Gatters rückgeführt ist.

Unabhängig von dem konkreten Aufbau muß bei den RS-Flip-Flops der Figuren 2 und 3 ein Signal vom Eingangsanschluß IN bis zu einem Ausgangsanschluß Q des Flip-Flops 3 insgesamt drei Gatter durchlaufen, nämlich beispielsweise die Gatter 1, 5 und 7 bei dem Ausführungsbeispiel von Figur 3. Dadurch ist aber eine relativ lange Laufzeit bedingt, so daß die bestehenden RS-Flip-Flops ziemlich langsam sind und nicht schnell einen Impuls aufzubauen vermögen.

Es ist daher Aufgabe der vorliegenden Erfindung, ein RS-Flip-Flop zu schaffen, das sich durch eine besonders kurze Laufzeit auszeichnet und sehr schnell einen Impuls aufzubauen vermag.

Diese Aufgabe wird bei einem RS-Flip-Flop der eingangs genannten Art erfindungsgemäß durch die im Patentanspruch 1 definierten Merkmale gelöst.

Ein erster wesentlicher Vorteil des erfindungsgemäßen RS-Flip-Flops liegt darin, daß es mit vier Transistoren weniger auskommt als herkömmliche Flip-Flops. Außerdem braucht bei dem angegebenen Aufbau ein Signal zwischen dem Eingangsanschluß des RS-Flip-Flops und dessen Ausgangsanschluß lediglich ein Gatter zu durchlaufen, da der Ausgang des Inverters über den gemeinsamen Verbindungspunkt des Haltegliedes direkt mit dem Ausgangsanschluß des RS-Flip-Flops verbunden ist, was zu einer äußerst kurzen Laufzeit führt, so daß das RS-Flip-Flop sehr schnell ist. Durch die Ansteuerung der dritten und vierten Transistoren des Haltegliedes über das NOR-Gatter bzw. das NAND-Gatter wird erreicht, daß ein "verbotener Zustand" der Reihenschaltung der dritten und vierten Transistoren ausgeschlossen wird, bei welchem diese die Betriebsspannung VDD mit der Bezugsspannung VSS kurzschließen würden.

Der Inverter besteht in üblicher Weise aus einem P-Kanal-MOS-Transistor, der in Reihe zu einem N-Kanal-MOS-Transistor geschaltet ist. Der erste Transistor, der über das NOR-Gatter angesteuert ist, ist dann ebenfalls ein P-Kanal-MOS-Transistor, der zwischen der Betriebsspannung und Drain bzw. Source des P-Kanal-MOS-Transistors des Inverters verbunden ist. In ähnlicher Weise ist der über das NAND-Gatter angesteuerte zweite Transistor ein N-Kanal-MOS-Transistor, der in Reihe zwischen der Bezugsspannung VSS und Drain bzw. Source des N-Kanal-MOS-Transistors des Inverters geschaltet ist. Gate des ersten Transistors ist mit Gate des dritten Transistors verbunden, bei dem es sich um einen N-Kanal-MOS-Transistor handelt. Ebenso ist Gate des zweiten Transistors mit Gate des vierten Transistors verbunden, der hier durch einen P-Kanal-MOS-Transistor gebildet wird. Der dritte und der vierte Transistor liegen in Reihe zwischen der Bezugsspannung und der Betriebsspannung.

Nachfolgend wird die Erfindung anhand der Zeichnungen näher erläutert. Es zeigen:

Fig. 1     ein Schaltbild eines Ausführungsbeispiels des erfindungsgemäßen RS-Flip-Flops,

Fig. 2     ein Blockschaltbild eines bestehenden RS-Flip-Flops, und

Fig. 3     ein Schaltbild für ein Flip-Flop der in Figur 2 dargestellten Art.

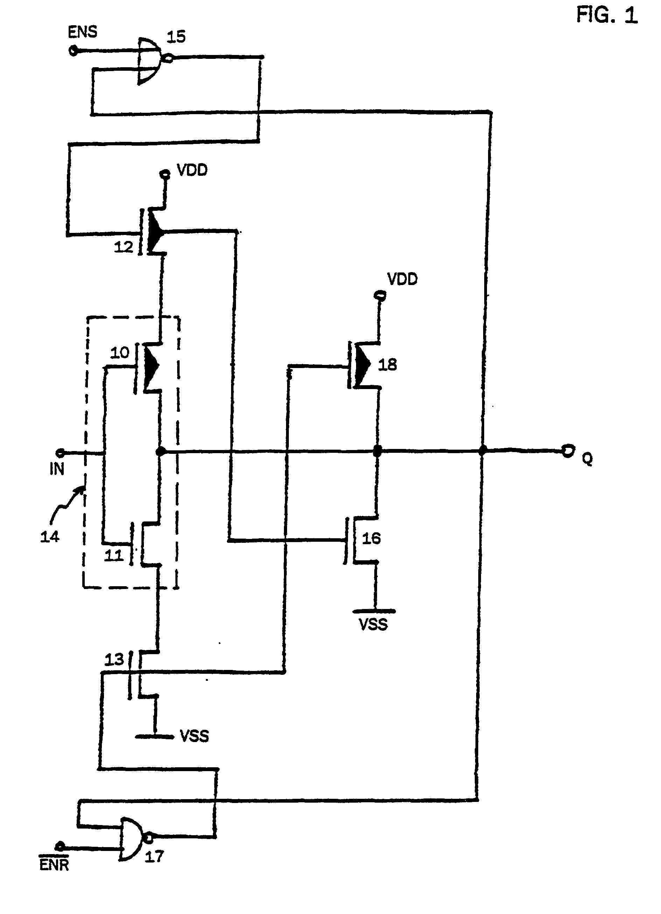

Figuren 2 und 3 sind bereits eingangs näher erläutert worden. In der Figur 1 werden für sich entsprechende Teile die gleichen Bezugszeichen wie in den Figuren 2 und 3 verwendet.

In Figur 1 ist ein Eingangsanschluß IN des RS-Flip-Flops mit den Gate-Elektroden von zwei in Reihe zueinander liegenden MOS-Transistoren 10, 11 verbunden, die einen Inverter bilden und von denen der Transistor 10 ein P-Kanal-MOS-Transistor ist, während der Transistor 11 ein N-Kanal-MOS-Transistor ist. In Reihe zu dem P-Kanal-MOS-Transistor 10 liegt ein weiterer P-Kanal-MOS-Transistor 12, während ein N-Kanal-MOS-Transistor 13 in Reihe zu dem N-Kanal-MOS-Transistor 11 geschaltet ist. Die Transistoren 10, 11 bilden einen Inverter 14, dessen Ausgang am Verbindungspunkt der Transistoren 10, 11 direkt mit dem Ausgangsanschluß Q des RS-Flip-Flops zusammengeschaltet ist.

Die Transistoren 10, 11, 12 und 13 liegen in Reihe zwischen der Betriebsspannung VDD und der Bezugsspannung VSS.

An einem Eingangsanschluß ENS eines NOR-Gatters 15 liegt ein Enable-Set-Signal, während der andere Eingang dieses NOR-Gatters 15 mit dem Ausgangsanschluß Q verbunden ist. Der Ausgangsanschluß des NOR-Gatters 15 ist über die Gateelektrode des Transistors 12 mit der Gateelektrode eines N-Kanal-MOS-Transistors 16 verbunden.

An einem Eingangsanschluß ENR (ENR ist invertiert zu ENR) eines NAND-Gatters 17 liegt ein Enable-Reset-Signal, während der andere Eingangsanschluß dieses NAND-Gatters 17 mit dem Ausgangsanschluß Q des RS-Flip-Flops verbunden ist. Der Ausgangsanschluß des NAND-Gatters 17 ist über die Gateelektrode des N-Kanal-MOS-Transistors 13 mit der Gateelektrode eines P-Kanal-MOS-Transistors 18 verbunden.

Die Transistoren 18 und 16 liegen in Reihe zwischen der Betriebsspannung VDD und der Bezugsspannung VSS, und ihr gemeinsamer Verbindungspunkt ist an den Ausgangsanschluß Q bzw. an den Verbindungspunkt der Transistoren 10, 11 angeschlossen.

In der folgenden Tabelle sind die verschiedenen Zustände des Flip-Flops für ein Setzsignal ens am Anschluß ENS, ein Rücksetzsignal enr am Anschluß ENR, ein Signal $q^{-1}$ am Ausgangsanschluß Q für den Zustand vor dem Schalten, ein Signal "in" am Eingangsanschluß IN und ein Signal q am Ausgangsanschluß Q nach dem Schalten angegeben, wobei "x" ein beliebiges Signal und D Daten bedeuten sowie in üblicher Weise "1" für "enable" und "0" für "disable" stehen.

Im 1. Zustand ist das Flip-Flop bereit zum Rücksetzen (vgl. linke Hälfte der entsprechenden Spalte), wobei das rückgesetzte Flip-Flop dann den Wert "0" speichert (vgl. rechte Hälfte der Spalte). Wenn im 2. Zustand dann am Anschluß ENS das Signal "0" liegt und der Ausgangsanschluß Q auch den Wert "0" hat, so wird unabhängig davon, welche Signale "x" den Anschlüssen ENR und IN zugeführt sind, "0" gespeichert. Im 3. Zustand ist das Flip-Flop bereit zum Setzen (vgl. linke Hälfte der entsprechenden Spalte), wobei das gesetzte Flip-Flop dann den Wert "1" speichert (vgl. rechte Hälfte der Spalte). Wenn im 4. Zustand dann am Anschluß ENR das Signal "1" (bzw. "0" an $\overline{ENR}$) liegt und der Ausgangsanschluß Q ebenfalls den Wert "1" hat, so wird unabhängig davon, welche Signale "x" den Anschlüssen ENS und IN zugeführt sind, "1" gespeichert. Im fünften Zustand speichert das Flip-Flop die Daten D, während im sechsten Zustand das Flip-Flop "transparent" ist und die Funktion eines Inverters ausübt.

| Tabelle | 1. Zustand | | 2. Zustand | 3. Zustand | | 4. Zustand | 5. Zustand | 6. Zustand |
|---|---|---|---|---|---|---|---|---|
| ens | 0 | | 0 | 1 | | x | 0 | 1 |
| $\overline{enr}$ | 1 | | x | 0 | | 0 | 0 | 1 |
| $q^{-1}$ | 1 | | 0 | 0 | | 1 | D | |
| in | | | x | | | x | | D |
| q | 1 | 0 | 0 | 0 | 1 | 1 | D | $\overline{D}$ |

wie sofort aus der Figur 1 zu ersehen ist, wird ein am Eingangsanschluß IN liegendes Signal durch nur ein Gatter aus den Transistoren 10, 11 dem Ausgangsanschluß Q zugeführt, so daß die Laufzeit eines Signales äußerst kurz ist. Das erfindungsgemäße RS-Flip-Flop vermag also einen Impuls sehr schnell aufzubauen.

**Patentansprüche**

1. RS-Flip-Flop mit einem mit einem Eingangsanschluß (IN) verbundenen Inverter (14), einem einen Enable-Set-Anschluß (ENS) aufweisenden NOR-Gatter (15) und einem einen Enable-Reset-Anschluß (ENR) aufweisenden NAND-Gatter (17) und jeweils einem mit dem Inverter (14) verbundenen ersten und zweiten Transistor (12 bzw. 13), wobei,
der Ausgang des NOR- bzw. NAND-Gatters (15, 17) über die Gate-Strecke des ersten bzw. zweiten Transistors (12 bzw. 13) mit der Gateelektrode von jeweils einem von zwei in Reihe liegenden und ein Halteglied bildenden dritten und vierten Transistoren (16 bzw. 18) verbunden ist, deren gemeinsamer Verbindungspunkt mit dem Ausgang des Inverters (14) und dem Ausgangsanschluß (Q) des Flip-Flops zusammengeschaltet ist, und wobei der Ausgangsanschluß (Q) des Flip-Flops mit dem anderen Eingangsanschluß des NOR-Gatters (15) bzw. des NAND-Gatters (17) verbunden ist.

**2.** RS-Flip-Flop nach Anspruch 1,
**dadurch gekennzeichnet,**
**daß** der erste Transistor (12) ein P-Kanal-MOS-Transistor ist, der in Reihe mit einem P-Kanal-MOS-Transistor (10) des Inverters (14) verbunden ist.

**3.** RS-Flip-Flop nach Anspruch 1 oder 2,
**dadurch gekennzeichnet,**
**daß** der zweite Transistor (13) ein N-Kanal-MOS-Transistor ist, der in Reihe mit einem N-Kanal-MOS-Transistor (11) des Inverters (14) verbunden ist.

**4.** RS-Flip-Flop nach Anspruch 3,
**dadurch gekennzeichnet,**
**daß** der erste Transistor (12), der Inverter (14) und der zweite Transistor (13) in Reihe zwischen einer Betriebsspannung (VDD) und einer Bezugsspannung (VSS) liegen.

**5.** RS-Flip-Flop nach einem der Ansprüche 1 bis 4,
**dadurch gekennzeichnet,**
**daß** der dritte Transistor (16) ein N-Kanal-MOS-Transistor ist.

**6.** RS-Flip-Flop nach einem der Ansprüche 1 bis 5,
**dadurch gekennzeichnet,**
**daß** der vierte Transistor (18) ein P-Kanal-MOS-Transistor ist.

**7.** RS-Flip-Flop nach einem der Ansprüche 1 bis 6,
**dadurch gekennzeichnet,**
**daß** der dritte und der vierte Transistor (16, 18) in Reihe zwischen der Bezugsspannung (VSS) und der Betriebsspannung (VDD) liegen.

**Claims**

**1.** RS flip-flop having an invertor (14) connected to an input connection (IN), having a NOR gate (15) which has an Enable-Set connection (ENS), having a NAND gate (17) which has an Enable-Reset connection (ENR), and in each case having a first and a second transistor (12 and 13, respectively) connected to the invertor (14), where the outputs of the NOR and NAND gates (15, 17) are connected, via the gate paths of the first and second transistors (12 and 13, respectively), to the gate electrode of in each case one of two third and fourth transistors (16 and 18, respectively) which are connected in series, form a latching element, and whose common connection point is connected to the output of the invertor (14) and to the output connection (Q) of the flip-flop, and where the output connection (Q) of the flip-flop is connected to the other input connection of the NOR gate (15) and of the NAND gate (17).

**2.** RS flip-flop according to Claim 1, **characterized in that** the first transistor (12) is a p-channel MOS transistor which is connected in series with a p-channel MOS transistor (10) of the invertor (14).

**3.** RS flip-flop according to Claim 1 or 2, **characterized in that** the second transistor (13) is an n-channel MOS transistor which is connected in series with an n-channel MOS transistor (11) of the invertor (14).

**4.** RS flip-flop according to Claim 3,
**characterized in that** the first transistor (12), the invertor (14) and the second transistor (13) are arranged in series between an operating voltage (VDD) and a reference-earth voltage (VSS).

**5.** RS flip-flop according to one of Claims 1 to 4, **characterized in that** the third transistor (16) is an n-channel MOS transistor.

**6.** RS flip-flop according to one of Claims 1 to 5, **characterized in that** the fourth transistor (18) is a p-channel MOS transistor.

**7.** RS flip-flop according to one of Claims 1 to 6, **characterized in that** the third and fourth transistors (16, 18) are arranged in series between the reference-earth voltage (VSS) and the operating voltage (VDD).

**Revendications**

1.  Bascule RS comprenant un inverseur (14) relié à une borne (IN) d'entrée, une porte (15) NON-OU ayant une borne (ENS) Enable-Set et une porte (17) NON-ET ayant une borne (ENR) Enable-Reset et respectivement un premier et un deuxième transistor (12 et 13) reliés à l'inverseur (14),
    dans laquelle la sortie de la porte (15, 17) NON-OU ou NON-ET est reliée par la section grille du premier ou du deuxième transistor (12 et 13) à l'électrode de grille de respectivement l'un de deux troisième et quatrième transistors (16 et 18) montés en série et formant un élément de maintien dont le point commun de liaison est interconnecté à la sortie de l'inverseur (14) et à la borne (Q) de sortie de la bascule, et
    dans laquelle la borne (Q) de sortie de la bascule est reliée à l'autre borne d'entrée de la porte (15) NON-OU et de la porte (17) NON-ET.

2.  Bascule RS suivant la revendication 1,
    **caractérisée**
    **en ce que** le premier transistor (12) est un transistor MOS à canal P qui est monté en série avec un transistor (10) MOS à canal P de l'inverseur (14).

3.  Bascule RS suivant la revendication 1 ou 2,
    **caractérisée**
    **en ce que** le deuxième transistor (13) est un transistor MOS à canal N qui est monté en série avec un transistor (11) MOS à canal N de l'inverseur (14).

4.  Bascule RS suivant la revendication 3,
    **caractérisée**
    **en ce que** le premier transistor (12), l'inverseur (14) et le deuxième transistor (13) sont montés en série entre une tension (VDD) de service et une tension (VSS) de référence.

5.  Bascule RS suivant l'une des revendications 1 à 4,
    **caractérisée**
    **en ce que** le troisième transistor (16) est un transistor MOS à canal N.

6.  Bascule RS suivant l'une des revendications 1 à 5,
    **caractérisée**
    **en ce que** le quatrième transistor (18) est un transistor MOS à canal P.

7.  Bascule RS suivant l'une des revendications 1 à 6,
    **caractérisée**
    **en ce que** le troisième et le quatrième transistor (16, 18) sont
    montés en série entre la tension (VSS) de référence et la tension (VDD) de service.

FIG. 1

FIG. 2

FIG. 3